# FASCICULE DE BREVET EUROPEEN

(11) **EP 3 469 111 B1**
(45) Date de publication et mention de la délivrance du brevet: **22.07.2020**
(21) Numéro de dépôt: 17734792.9
(22) Date de dépôt: 09.06.2017
(51) Int. Cl.: C23C 10/28, C22C 19/05

(54) **PROCÉDÉ DE FABRICATION D'UNE PIÈCE EN SUPERALLIAGE À BASE DE NICKEL CONTENANT DE L'HAFNIUM**
VERFAHREN ZUR HERSTELLUNG EINES AUS NICKELBASIERTER SUPERLEGIERUNG MIT HAFNIUM GEFERTIGTEN TEILS
PROCESS FOR MANUFACTURING A PART MADE OF NICKEL-BASED SUPERALLOY CONTAINING HAFNIUM

(30) Priorité: 10.06.2016 FR 1655343
(43) Date de publication de la demande: 17.04.2019
(73) Titulaire: Safran, 75015 Paris (FR)
(72) Inventeur: SABOUNDJI, Amar, 77550 Moissy-cramayel (FR); JAQUET, Virginie, 77550 Moissy-cramayel (FR)
(74) Mandataire: Regimbeau
(86) Numéro de dépôt international: PCT/FR2017/051475
(87) Numéro de publication internationale: WO 2017/212195

(56) Documents cités:
- EP-A1- 0 718 420
- EP-A1- 0 821 078
- EP-A1- 1 010 774
- EP-A1- 1 036 850
- EP-A1- 1 447 457
- EP-A1- 2 239 351

## Description

### DOMAINE TECHNIQUE GENERAL

La présente invention concerne un procédé de fabrication de superalliages à base de nickel contenant de l'hafnium.

### ETAT DE L'ART

On connaît déjà dans l'état de la technique, des superalliages à base de nickel.

Par "superalliages", on entend des alliages complexes présentant, à haute température et à haute pression, une très bonne résistance à l'oxydation, à la corrosion, au fluage et à des contraintes cycliques (notamment mécaniques ou thermiques). Ces superalliages trouvent une application particulière dans la fabrication de pièces utilisées dans l'aéronautique, par exemple des aubes de turbine.

Les superalliages peuvent être durcis par un traitement dit "de mise en solution". Un tel traitement consiste à chauffer l'alliage à une température appropriée élevée, inférieure à la température eutectique et à maintenir cette température suffisamment longtemps pour homogénéiser les concentrations élémentaires de ses constituants et contrôler la taille des précipités intermétalliques. Ceci permet d'optimiser les propriétés microstructurales du matériau.

Afin d'améliorer encore la tenue à l'oxydation des superalliages à base de nickel, on ajoute volontairement à ceux-ci de l'hafnium. Cependant, la présence d'hafnium dans le superalliage rend plus difficile la mise en solution totale ou quasi-totale des eutectiques et entraine des défauts de brûlures.

Le document EP 1 036 850 A1 décrit un tel procédé de fabrication d'un superalliage à base de nickel contenant du hafnium connu de l'art antérieur.

### PRESENTATION DE L'INVENTION

L'invention a donc pour objectif de résoudre les inconvénients précités de l'état de la technique et de proposer un procédé de fabrication d'un superalliage à base de nickel contenant de l'hafnium permettant d'obtenir un superalliage qui conserve le rôle bénéfique de l'hafnium dans l'amélioration de la tenue à l'oxydation et à la corrosion mais sans avoir les inconvénients d'une mise en solution difficile.

A cet effet, l'invention concerne un procédé de fabrication d'une pièce en superalliage monocristallin à base de nickel contenant de l'hafnium.

Conformément à l'invention, ce procédé comprend les étapes successives suivantes consistant à :
- fabriquer un superalliage monocristallin, non dopé à l'hafnium, à base de nickel,
- fabriquer une pièce à partir de ce superalliage,
- - déposer directement sur ladite pièce, une couche d'hafnium, d'une épaisseur comprise entre 50 nm et 800 nm,
- réaliser un traitement de diffusion de l'hafnium de façon à former une couche d'interdiffusion en surface de ladite pièce, et à obtenir ainsi une pièce en superalliage monocristallin à base de nickel contenant de l'hafnium.

Grâce à ces caractéristiques de l'invention, le superalliage obtenu présente des propriétés mécaniques améliorées grâce à une mise en solution quasi-totale ou améliorée des eutectiques tout en conservant une bonne résistance à l'oxydation et à la corrosion. L'utilisation d'une couche d'hafnium pur renforce encore cette résistance à l'oxydation.

Selon d'autres caractéristiques avantageuses et non limitatives de l'invention, prises seules ou en combinaison :
- le superalliage monocristallin à base de nickel non dopé à l'hafnium comprend en pourcentage massique :
- 5,2 % d'aluminium, 6,5 % de cobalt, 7,8 % de chrome, 2 % de molybdène, 7,9 % de tantale, 1,1 % de titane, 5,7 % de tungstène et le reste de nickel ou
- 5,6 % d'aluminium, 9,6 % de cobalt, 6,5 % de chrome, 0,6 % de molybdène, 3 % de rhénium, 6,5 % de tantale, 1 % de titane, 6 % de tungstène et le reste de nickel ou
- 5,73 % d'aluminium, 9,6 % de cobalt, 3,46 % de chrome, 0,6 % de molybdène, 4,9 % de rhénium, 8,3 % de tantale, 0,9 % de titane, 5,5 % de tungstène et le reste de nickel ou
- 5,7 % d'aluminium, 3 % de cobalt, 2 % de chrome, 0,4 % de molybdène, 6 % de rhénium, 8 % de tantale, 0,2 % de titane, 5 % de tungstène, 0,1 % de niobium et le reste de nickel ou
- 5,8 % d'aluminium, 12,5 % de cobalt, 4,2 % de chrome, 1,4 % de molybdène, 5,4 % de rhénium, 7,2 % de tantale, 6 % de tungstène et le reste de nickel ou
- 6 % d'aluminium, moins de 0,2 % de cobalt, 4 % de chrome, 1 % de molybdène, 4 % de rhénium, 5 % de tantale, 0,5 % de titane, 5 % de tungstène, 4% de ruthénium et le reste de nickel.

### DESCRIPTION DETAILLEE

Le procédé conforme à l'invention consiste tout d'abord à fabriquer un superalliage monocristallin, non dopé à l'hafnium, à base de nickel. Par « non dopé à l'hafnium », on entend exempt d'hafnium.

Le tableau 1 ci-dessous cite plusieurs exemples préférentiels des superalliages susceptibles d'être utilisés dans le procédé conforme à l'invention. Ils sont identifiés par les lettres A à F. D'autres superalliages monocristallins à base de nickel non dopés à l'hafnium peuvent également être utilisés.

**Tableau 1**

| Exemples de superalliages monocristallins à base de nickel sans hafnium | | | | | | | | | | | |
|---|---|---|---|---|---|---|---|---|---|---|---|
| | **Eléments alliages (pourcentages massiques)** | | | | | | | | | | |
| | **Ni** | **Al** | **Co** | **Cr** | **Mo** | **Re** | **Ta** | **Ti** | **W** | **Cb** | **Ru** |
| A | Reste | 5,2 | 6,5 | 7,8 | 2 | 0 | 7,9 | 1,1 | 5,7 | | |
| B | Reste | 5,6 | 9,6 | 6,5 | 0,6 | 3 | 6,5 | 1 | 6 | | |
| C | Reste | 5,73 | 9,6 | 3,46 | 0,6 | 4,87 | 8,28 | 0,86 | 5,5 | | |
| D | Reste | 5,7 | 3 | 2 | 0,4 | 6 | 8 | 0,2 | 5 | 0,1 | |
| E | Reste | 5,8 | 12,5 | 4,2 | 1,4 | 5,4 | 7,2 | 0 | 6 | | |
| F | Reste | 6 | <0,2 | 4 | 1 | 4 | 5 | 0,5 | 5 | | 4 |

Le terme "reste" correspond, pour chaque superalliage, au pourcentage massique résiduel pour atteindre 100% avec les différents autres composants mentionnés.

On forme ensuite une pièce présentant une forme souhaitée à partir d'un tel superalliage, par exemple par fonderie ou par fabrication additive.

De préférence, on soumet ensuite la pièce obtenue à un traitement de mise en solution, et ce comme exposé précédemment dans l'introduction.

De préférence, ce traitement consiste en une première étape de montée en température jusqu'à atteindre une température d'environ 1100°C pendant une durée comprise entre quelques minutes à 4 heures, suivie d'une deuxième étape de montée en température jusqu'à atteindre une température d'environ 1200°C pendant une durée comprise entre quelques minutes à 4 heures, et enfin une troisième étape de montée en température jusqu'à atteindre une température d'environ 1300°C pendant une durée comprise entre quelques minutes à 4 heures.

On dépose ensuite sur ladite pièce ainsi fabriquée, une couche d'hafnium, c'est-à-dire soit une couche d'hafnium pur (100% atomique d'hafnium), soit une couche contenant au moins 99,99% atomique d'hafnium. Cette couche est de préférence nanocristalline ou microcristalline. De préférence, cette couche présente une épaisseur comprise entre 50 nm et 800 nm, de préférence encore comprise entre 50 nm et 300 nm.

Le dépôt de cette couche d'hafnium peut être réalisé par dépôt physique en phase vapeur (PVD), de préférence par pulvérisation cathodique. Ceci permet de bien contrôler l'épaisseur déposée.

On peut également citer l'emploi du dépôt physique en phase vapeur par faisceau d'électrons (EBPVD pour *"electron beam chemical vapor deposition"*), l'évaporation, l'ablation par laser pulsé ou la pulvérisation cathodique. Cette dernière technique a l'avantage de permettre la formation de films denses, d'une épaisseur nanométrique ou micrométrique et qui présentent une adhérence sur la couche précédente supérieure à celle obtenue avec les autres techniques de dépôt.

Le dépôt PVD s'effectue à l'intérieur d'une enceinte contenant la pièce et une ou plusieurs cibles correspondant au(x) matériau(x) à déposer, ici notamment l'hafnium. Sous l'application d'une différence de potentiel entre les parois du réacteur et la (les) cible(s), un plasma se forme dont les espèces positives sont attirées par la cathode (cible) et entrent en collision avec celle(s)-ci. Les atomes de la ou des cible(s) sont pulvérisés et se condensent alors sur ladite pièce.

De préférence, les conditions de dépôt sont les suivantes :
- Chauffage pendant le dépôt : de 100 à 900°C
- Pression : de 0,1 Pa à 1 Pa
- Densité de puissance : 2 à 15 W/cm2
- Polarisation : - 500V à -150 V

Le bombardement ionique est réalisé pendant 10 à 30 minutes entre -200V et 500V.

Le dépôt de la couche d"hafnium peut également être réalisé par dépôt chimique en phase vapeur (CVD).

Parmi les techniques de dépôts chimiques en phase vapeur (CVD), on peut citer par exemple :
- le dépôt chimique en phase vapeur assisté par plasma (PECVD pour *"plasma enhanced chemical vapor deposition"*),
- le dépôt chimique en phase vapeur à basse pression (LPCVD pour *"low pressure chemical vapor deposition"*),
- le dépôt chimique en phase vapeur sous ultravide (UHVCVD pour *"ultra high vacuum chemical vapor deposition"*),
- le dépôt chimique en phase vapeur à la pression atmosphérique (APCVD pour *"atmospheric pressure chemical vapor deposition"*),
- le dépôt chimique en phase vapeur de couches atomiques (ALCVD pour *"atomic layer chemical vapor deposition"*),
- l'aluminisation chimique en phase vapeur (CVA pour "chemical vapor aluminization).

Ladite pièce est alors soumise à un traitement de diffusion de l'hafnium, de façon à former à la surface de ladite pièce, une couche d'interdiffusion, dans laquelle de l'hafnium est présent.

De préférence, le traitement de diffusion est réalisé en plaçant la pièce recouverte de la couche d'hafnium à l'intérieur d'une enceinte, en amenant celle-ci sous vide ou en introduisant à l'intérieur de celle-ci une atmosphère contenant un mélange de 95% en volume d'argon et de 5% en volume d'hélium, puis en effectuant le traitement thermique décrit ci-après.

De préférence, ce traitement thermique comprend une phase de montée en température, jusqu'à atteindre une température comprise entre 500°C et 1200°C, une phase de maintien de ce palier de température pendant une durée de 1 heure à 4 heures et une phase de refroidissement qui consiste à faire diminuer la température à l'intérieur de l'enceinte jusqu'à retourner à la température ambiante.

Le procédé conforme à l'invention présente de nombreux avantages cités ci-après.

Lors de la première étape du procédé, l'élaboration d'un superalliage monocristallin à base de nickel non dopé à l'hafnium et son utilisation pour la fabrication d'une pièce ne présentent pas de difficultés.

Au contraire, dans l'état de la technique (superalliage dopé en hafnium), la mise en forme de la pièce, notamment par fonderie, aboutissait lors de sa solidification à des pertes d'hafnium qui étaient différentes selon la géométrie de la pièce ou son temps de solidification. De même cette pièce risquait de s'oxyder (formation d'oxyde d'hafnium). Ceci n'est pas le cas avec le procédé de l'invention puisqu'il n'y a pas d'hafnium à ce stade.

Lors de l'étape de mise en solution, l'homogénéisation des constituants de la pièce et la remise en solution du superalliage sont optimales.

Lors des attaques chimiques réalisées dans le cadre du contrôle non destructif des pièces, il n'y a pas d'attaque préférentielle des eutectiques résiduels.

Enfin, le dépôt ultérieur de la couche d'hafnium et sa diffusion aboutissent à la formation d'une pièce plus robuste, présentant une meilleure tenue mécanique via une mise en solution quasi-totale ou améliorée des eutectiques et une meilleure tenue à l'oxydation et à la corrosion.

## Revendications

1. Procédé de fabrication d'une pièce en superalliage monocristallin à base de nickel contenant de l'hafnium, **caractérisé en ce qu'**il comprend les étapes successives suivantes consistant à :
- fabriquer un superalliage monocristallin, non dopé à l'hafnium, à base de nickel,
- fabriquer une pièce à partir de ce superalliage,
- déposer directement sur ladite pièce, une couche d'hafnium, d'une épaisseur comprise entre 50 nm et 800 nm,
- réaliser un traitement de diffusion de l'hafnium de façon à former une couche d'interdiffusion en surface de ladite pièce, et à obtenir ainsi une pièce en superalliage monocristallin à base de nickel contenant de l'hafnium.

2. Procédé selon la revendication 1, **caractérisé en ce que** le dépôt de la couche d'hafnium est réalisé par dépôt physique en phase vapeur (PVD).

3. Procédé selon la revendication 2, **caractérisé en ce que** le dépôt de la couche d'hafnium est réalisé par pulvérisation cathodique.

4. Procédé selon la revendication 1, **caractérisé en ce que** le dépôt de la couche d'hafnium est réalisé par dépôt chimique en phase vapeur (CVD), de préférence par une technique choisie parmi le dépôt chimique en phase vapeur à basse pression (LPCVD), l'aluminisation chimique en phase vapeur (CVA), le dépôt chimique en phase vapeur sous ultravide (UHVCVD), le dépôt chimique en phase vapeur assisté par plasma (PECVD), le dépôt chimique en phase vapeur à la pression atmosphérique (APCVD), le dépôt chimique en phase vapeur de couches atomiques (ALCVD).

5. Procédé selon l'une des revendications précédentes, **caractérisé en ce que** la couche d'hafnium déposée sur ladite pièce présente une épaisseur comprise entre 50 nm et 300 nm.

6. Procédé selon l'une des revendications précédentes, **caractérisé en ce que** le traitement de diffusion de l'hafnium est réalisé sous vide ou sous un mélange de 95% en volume d'argon et de 5% en volume d'hélium, en effectuant une montée en température jusqu'à amener ladite pièce à une température comprise entre 500°C et 1200°C, maintenir cette température pendant 1 heure à 4 heures et refroidir ladite pièce jusqu'à l'amener à température ambiante.

7. Procédé selon l'une des revendications précédentes, **caractérisé en ce que** le superalliage monocristallin à base de nickel non dopé à l'hafnium comprend en pourcentage massique 5,2 % d'aluminium, 6,5 % de cobalt, 7,8 % de chrome, 2 % de molybdène, 7,9 % de tantale, 1,1 % de titane, 5,7 % de tungstène et le reste de nickel.

8. Procédé selon l'une des revendications 1 à 6, **caractérisé en ce que** le superalliage monocristallin à base de nickel non dopé à l'hafnium comprend en pourcentage massique 5,6 % d'aluminium, 9,6 % de cobalt, 6,5 % de chrome, 0,6 % de molybdène, 3 % de rhénium, 6,5 % de tantale, 1 % de titane, 6 % de tungstène et le reste de nickel.

9. Procédé selon l'une des revendications 1 à 6, **caractérisé en ce que** le superalliage monocristallin à base de nickel non dopé à l'hafnium comprend en pourcentage massique 5,73 % d'aluminium, 9,6 % de cobalt, 3,46 % de chrome, 0,6 % de molybdène, 4,9 % de rhénium, 8,3 % de tantale, 0,9 % de titane, 5,5 % de tungstène et le reste de nickel.

10. Procédé selon l'une des revendications 1 à 6, **caractérisé en ce que** le superalliage monocristallin à base de nickel non dopé à l'hafnium comprend en pourcentage massique 5,7 % d'aluminium, 3 % de cobalt, 2 % de chrome, 0,4 % de molybdène, 6 % de rhénium, 8 % de tantale, 0,2 % de titane, 5 % de tungstène, 0,1 % de niobium et le reste de nickel.

11. Procédé selon l'une des revendications 1 à 6, **caractérisé en ce que** le superalliage monocristallin à base de nickel non dopé à l'hafnium comprend en pourcentage massique 5,8 % d'aluminium, 12,5 % de cobalt, 4,2 % de chrome, 1,4 % de molybdène, 5,4 % de rhénium, 7,2 % de tantale, 6 % de tungstène et le reste de nickel.

12. Procédé selon l'une des revendications 1 à 6, **caractérisé en ce que** le superalliage monocristallin à base de nickel non dopé à l'hafnium comprend en pourcentage massique 6 % d'aluminium, moins de 0,2 % de cobalt, 4 % de chrome, 1 % de molybdène, 4 % de rhénium, 5 % de tantale, 0,5 % de titane, 5 % de tungstène, 4% de ruthénium et le reste de nickel.

## Patentansprüche

1. Verfahren zur Herstellung eines Teils aus einkristalliner Superlegierung auf Nickelbasis mit Hafnium, **dadurch gekennzeichnet, dass** es die folgenden aufeinanderfolgenden Schritte umfasst, die bestehen im:
- Herstellen einer nicht mit Hafnium dotierten einkristallinen Superlegierung auf Nickelbasis,
- Herstellen eines Teils aus dieser Superlegierung,
- direkten Abscheiden einer Hafniumschicht mit einer Dicke, die zwischen 50 nm und 800 nm beträgt, auf dem Teil,
- Ausführen einer Behandlung zur Diffusion des Hafniums, derart dass eine Interdiffusionsschicht auf der Oberfläche des Teils gebildet wird und somit ein Teil aus einkristalliner Superlegierung auf Nickelbasis mit Hafnium erhalten wird.

2. Verfahren nach Anspruch 1, **dadurch gekennzeichnet, dass** das Abscheiden der Hafniumschicht durch physikalische Gasphasenabscheidung (PVD) ausgeführt wird.

3. Verfahren nach Anspruch 2, **dadurch gekennzeichnet, dass** das Abscheiden der Hafniumschicht durch Kathodenzerstäubung ausgeführt wird.

4. Verfahren nach Anspruch 1, **dadurch gekennzeichnet, dass** das Abscheiden der Hafniumschicht durch chemische Gasphasenabscheidung (CVD), vorzugsweise durch eine Technik ausgeführt wird, die unter chemischer Niederdruck-Gasphasenabscheidung (LPCVD), chemischer Gasphasenaluminisierung (CVA), chemischer Ultrahochvakuum-Gasphasenabscheidung (UHVCVD), plasmaunterstützter chemischer Gasphasenabscheidung (PECVD), chemischer Gasphasenabscheidung bei Atmosphärendruck (APCVD), chemischer Gasphasen-Atomlagenabscheidung (ALCVD) gewählt wird.

5. Verfahren nach einem der vorhergehenden Ansprüche, **dadurch gekennzeichnet, dass** die auf dem Teil abgeschiedene Hafniumschicht eine Dicke aufweist, die zwischen 50 nm und 300 nm beträgt.

6. Verfahren nach einem der vorhergehenden Ansprüche, **dadurch gekennzeichnet, dass** die Behandlung zur Diffusion des Hafniums im Vakuum oder in einer Mischung aus 95 Vol.-% Argon und 5 Vol.-% Helium durch Durchführen eines Temperaturanstiegs, bis das Teil auf eine Temperatur gebracht wird, die zwischen 500°C und 1200°C beträgt, Aufrechterhalten dieser Temperatur während 1 Stunde bis 4 Stunden und Abkühlen des Teils, bis es auf Umgebungstemperatur gebracht wird, ausgeführt wird.

7. Verfahren nach einem der vorhergehenden Ansprüche, **dadurch gekennzeichnet, dass** die nicht mit Hafnium dotierte einkristalline Superlegierung auf Nickelbasis 5,2 Ma.-% Aluminium, 6,5 Ma.-% Kobalt, 7,8 Ma.-% Chrom, 2 Ma.-% Molybdän, 7,9 Ma.-% Tantal, 1,1 Ma.-% Titan, 5,7 Ma.-% Wolfram und den Rest Nickel umfasst.

8. Verfahren nach einem der Ansprüche 1 bis 6, **dadurch gekennzeichnet, dass** die nicht mit Hafnium dotierte einkristalline Superlegierung auf Nickelbasis 5,6 Ma.-% Aluminium, 9,6 Ma.-% Kobalt, 6,5 Ma.-% Chrom, 0,6 Ma.-% Molybdän, 3 Ma.-% Rhenium, 6,5 Ma.-% Tantal, 1 Ma.-% Titan, 6 Ma.-% Wolfram und den Rest Nickel umfasst.

9. Verfahren nach einem der Ansprüche 1 bis 6, **dadurch gekennzeichnet, dass** die nicht mit Hafnium dotierte einkristalline Superlegierung auf Nickelbasis 5,73 Ma.-% Aluminium, 9,6 Ma.-% Kobalt, 3,46 Ma.-% Chrom, 0,6 Ma.-% Molybdän 4,9 Ma.-% Rhenium, 8,3 Ma.-% Tantal, 0,9 Ma.-% Titan, 5,5 Ma.-% Wolfram und den Rest Nickel umfasst.

10. Verfahren nach einem der Ansprüche 1 bis 6, **dadurch gekennzeichnet, dass** die nicht mit Hafnium dotierte einkristalline Superlegierung auf Nickelbasis 5,7 Ma.-% Aluminium, 3 Ma.-% Kobalt, 2 Ma.-% Chrom, 0,4 Ma.-% Molybdän, 6 Ma.-% Rhenium, 8 Ma.-% Tantal, 0,2 Ma.-% Titan, 5 Ma.-% Wolfram, 0,1 Ma.-% Niob und den Rest Nickel umfasst.

11. Verfahren nach einem der Ansprüche 1 bis 6, **dadurch gekennzeichnet, dass** die nicht mit Hafnium dotierte einkristalline Superlegierung auf Nickelbasis 5,8 Ma.-% Aluminium, 12,5 Ma.-% Kobalt, 4,2 Ma.-% Chrom, 1,4 Ma.-% Molybdän, 5,4 Ma.-% Rhenium, 7,2 Ma.-% Tantal, 6 Ma.-% Wolfram und den Rest Nickel umfasst.

12. Verfahren nach einem der Ansprüche 1 bis 6, **dadurch gekennzeichnet, dass** die nicht mit Hafnium dotierte einkristalline Superlegierung auf Nickelbasis 6 Ma.-% Aluminium, weniger als 0,2 Ma.-% Kobalt, 4 Ma.-% Chrom, 1 Ma.-% Molybdän, 4 Ma.-% Rhenium, 5 Ma.-% Tantal, 0,5 Ma.-% Titan, 5 Ma.-% Wolfram, 4 Ma.-% Ruthenium und den Rest Nickel umfasst.

## Claims

1. A process for manufacturing a hafnium-containing nickel-based single-crystal superalloy part, **characterized in that** it comprises the following successive steps consisting in:
- manufacturing a nickel-based, non-hafnium-doped, single-crystal superalloy,
- manufacturing a part from this superalloy,
- depositing, directly on said part, a layer of hafnium having a thickness comprised between 50 nm and 800 nm,
- carrying out a hafnium diffusion treatment so as to form an interdiffusion layer on the surface of said part, and thereby obtain a hafnium-containing nickel-based single-crystal superalloy part.

2. The process according to claim 1, **characterized in that** the deposition of the layer of hafnium is carried out by physical vapour deposition (PVD).

3. The process according to claim 2, **characterized in that** the deposition of the layer of hafnium is carried out by cathode sputtering.

4. The process according to claim 1, **characterized in that** the deposition of the layer of hafnium is carried out by chemical vapour deposition (CVD), preferably by a technique selected from low-pressure chemical vapour deposition (LPCVD), chemical vapour aluminizing (CVA), ultra-high vacuum chemical vapour deposition (UHVCVD), plasma enhanced chemical vapour deposition (PECVD), atmospheric pressure chemical vapour deposition (APCVD), atomic layer chemical vapour deposition (ALCVD).

5. The process according to one of the preceding claims, **characterized in that** the layer of hafnium deposited on said part has a thickness comprised between 50 nm and 300 nm.

6. The process according to one of the preceding claims, **characterized in that** the hafnium diffusion treatment is carried out under vacuum or under a mixture of 95 % by volume argon and 5 % by volume helium, by carrying out a temperature increase until bringing said part to a temperature comprised between 500°C and 1200°C, maintaining this temperature for 1 hour to 4 hours and cooling said part until it returns to room temperature.

7. The process according to one of the preceding claims, **characterized in that** the non-hafnium-doped nickel-based single-crystal superalloy comprises in mass percent 5.2 % aluminium, 6.5 % cobalt, 7.8 % chromium, 2 % molybdenum, 7.9 % tantalum, 1.1 % titanium, 5.7 % tungsten and the remainder nickel.

8. The process according to one of claims 1 to 6, **characterized in that** the non-hafnium-doped nickel-based single-crystal superalloy comprises in mass percent 5.6 % aluminium, 9.6 % cobalt, 6.5 % chromium, 0.6 % molybdenum, 3 % rhenium, 6.5 % tantalum, 1 % titanium, 6 % tungsten and the remainder nickel.

9. The process according to one of claims 1 to 6, **characterized in that** the non-hafnium-doped nickel-based single-crystal superalloy comprises in mass percent 5.73 % aluminium, 9.6 % cobalt, 3.46 % chromium, 0.6 % molybdenum, 4.9 % rhenium, 8.3 % tantalum, 0.9 % titanium, 5.5 % tungsten and the remainder nickel.

10. The process according to one of claims 1 to 6, **characterized in that** the non-hafnium-doped nickel-based single-crystal superalloy comprises in mass percent 5.7 % aluminium, 3 % cobalt, 2 % chromium, 0.4 % molybdenum, 6 % rhenium, 8 % tantalum, 0.2 % titanium, 5 % tungsten, 0.1 % niobium and the remainder nickel.

11. The process according to one of claims 1 to 6, **characterized in that** the non-hafnium-doped single-crystal nickel-based superalloy comprises in mass percent 5.8 % aluminium, 12.5 % cobalt, 4.2 % chromium, 1.4 % molybdenum, 5.4 % rhenium, 7.2 % tantalum, 6 % tungsten and the remainder nickel.

12. The process according to one of claims 1 to 6, **characterized in that** the non-hafnium-doped nickel-based single-crystal superalloy comprises in mass percent 6 % aluminium, less than 0.2 % cobalt, 4 % chromium, 1 % molybdenum, 4 % rhenium, 5 % tantalum, 0.5 % titanium, 5 % tungsten, 4 % ruthenium and the remainder nickel.
